**Europäisches Patentamt**

(19) **European Patent Office**

**Office européen des brevets**

(11) Veröffentlichungsnummer: **0 178 437**
**A1**

(12) # EUROPÄISCHE PATENTANMELDUNG

(21) Anmeldenummer: 85111040.3

(22) Anmeldetag: 02.09.85

(51) Int. Cl.⁴: **H 03 K 19/177**

(30) Priorität: 19.09.84 DE 3434398

(43) Veröffentlichungstag der Anmeldung:
23.04.86 Patentblatt 86/17

(84) Benannte Vertragsstaaten:
AT BE CH DE FR GB IT LI NL SE

(71) Anmelder: Siemens Aktiengesellschaft
Berlin und München Wittelsbacherplatz 2
D-8000 München 2(DE)

(72) Erfinder: Reichmeyer, Hans, Dipl.-Ing.
Sudetenstrasse 74
D-8018 Grafing(DE)

(72) Erfinder: Lawitzky, Gisbert, Dr. rer. nat.
Weltistrasse 14
D-8000 München 71(DE)

(72) Erfinder: Kuske, Editha, Dipl.-Inf.
Fasanenstrasse 36
D-8025 Unterhaching(DE)

(72) Erfinder: Duzy, Peter, Dipl.-Ing.
Passauerstrasse 54
D-8000 München 70(DE)

(54) **Programmierbare Schaltung in dynamischer C-MOS-Technik.**

(57) Eine programmierbare Schaltung besteht aus einer UND-Ebene (UD) zur Erzeugung von Produktermsignalen (PT) aus Eingangssignalen (E1) und aus einer ODER-Ebene (OD) zur Erzeugung von Summentermsignalen (ST) aus den Produktermsignalen (PT). Zur Erzeugung jedes Produktermsignals (PT) bzw. zur Erzeugung jedes Summentermsignals (ST) ist eine Teilschaltung (SE1 bzw. SE2) vorgesehen, die zwischen zwei Leitungen Verknüpfungstransistoren (TV) enthält und bei der die eine Leitung über einen Takttransistor (TT1) mit einem ersten Betriebspotential und die andere Leitung über einen anderen Takttransistor (TT2) mit einem zweiten Betriebspotential (P2) verbindbar ist. Das zweite Taktsignal (TS2) für die Takttransistoren der ODER-Ebene (OD) wird mit Hilfe einer Taktverzögerungsschaltung (TVZ) aus dem ersten Taktsignal (TS1) für die UND-Ebene (UD) gewonnen. Die Taktverzögerungsschaltung (TVZ) ist entspechend den Teilschaltungen (SE1) der UND-Ebene (UD) aufgebaut und enthält zusätzlich noch einen Kondensator (C). Einer der zwischen den Leitungen (L5, L6) liegenden Transistoren (TZ) ist ständig leitend gesteuert, die übrigen Transistoren sind ständig gesperrt. Durch diesen Aufbau und durch die entsprechende Dimensionierung des Kondensators (C) kann die Verzögerungszeit zwischen dem zweiten Taktsignal (TS2) und dem ersten Taktsignal (TS1) derart eingestellt werden, daß die ODER-Ebene (OD) erst dann in die Verarbeitungsphase eintritt, wenn alle Produktermsignale (PT) von den Teilschaltungen (SE1) der UND-Ebene erzeugt worden sind.

EP 0 178 437 A1

./...

# FIG 2

Siemens Aktiengesellschaft
Berlin und München

Unser Zeichen

**0178437**

VPA **84** P 1 7 2 0 E

## Programmierbare Schaltung in dynamischer-C-MOS-Technik

Die Erfindung bezieht sich auf eine programmierbare Schaltung in dynamischer C-MOS-Technik mit einer UND-Ebene, die Eingangssignale zu Produkttermen zusammenfaßt, und mit einer ODER-Ebene, die die Produktterme zu Summentermen zusammenfaßt, bei der die UND-Ebene zur Erzeugung eines Produkttermsignals bzw. die ODER-Ebene zur Erzeugung eines Summentermsignals jeweils eine Teilschaltung mit zwei Leitungen, von denen zur Vorladung die eine über einen von einem Taktsignal angesteuerten Takttransistor mit einem ersten Betriebspotential und die andere über einen zweiten von dem Taktsignal angesteuerten komplementär ausgeführten Takttransistor mit einem zweiten Betriebspotential verbindbar ist, und mit zwischen den Leitungen angeordneten von den Eingangssignalen bzw. Produkttermsignalen angesteuerten Verknüpfungstransistoren aufweist.

Programmierbare Schaltungen, abgekürzt PLA, sind bekannt (s. z.B. Weiß, Horninger, Integrierte MOS-Schaltungen, Springer Verlag 1982, S. 295 bis 298). Programmierbare Schaltungen können als statische Schaltungen in C-MOS-Technik aufgebaut sein und dann wegen der komplementären Struktur Serienschaltungen von Transistoren aufweisen. Sie sind daher nicht nur flächenintensiv, sondern auch langsam. Für schnelle und große C-MOS-PLA's kommt somit nur eine dynamische Schaltungstechnik in Betracht. Bei ihr werden in beiden Ebenen, der UND-Ebene und der ODER-Ebene, des PLA's in der einen Taktphase (Vorladephase) die Produkt- bzw. Summenterme des PLA's vorgeladen, in der anderen Taktphase (Verarbeitungsphase) je nach dem logischen Zustand der der UND-Ebene zugeführten Eingangssignalen aber eventuell entladen. Um ein vorzeitiges, und damit fälschliches

0178437

VPA 84 P 1720 E

Entladen der Summenterme zu vermeiden, müssen die beiden Ebenen des PLA's mit getrennten, gegeneinander in der Phase verschobenen Taktsignalen angesteuert werden. Das Taktsignal für die ODER-Ebene darf erst dann von Vorladen auf Verarbeiten umschalten, wenn alle Produktterme der UND-Ebene sicher erzeugt worden sind. Diese Schaltzeit ist aber abhängig von der Schaltungsauslegung, der Größe und der Belegung des PLA's.

Die Taktsignale für die UND-Ebene und für die ODER-Ebene des PLA's können extern erzeugt werden. Dann muß aber der Schaltungsentwickler sicherstellen, daß die Phasenverschiebung der beiden Taktsignale groß genug ist, um bei individuellen PLA's eine sichere Funktion zu gewährleisten.

Die der Erfindung zugrundeliegende Aufgabe besteht darin, die Taktsignale für die ODER-Ebene auf dem PLA selbst zu erzeugen und zwar so, daß das Taktsignal für die ODER-Ebene von der Vorladephase zur Verarbeitungsphase erst dann umschaltet, wenn die UND-Ebene alle Produktterme erzeugt hat.

Diese Aufgabe wird bei einer programmierbaren Schaltung der eingangs angegebenen Art dadurch gelöst, daß parallel zu den Teilschaltungen der der UND-Ebene zur Erzeugung des Taktsignals für die Teilschaltungen der ODER-Ebene eine Taktverzögerungsschaltung angeordnet ist, die entsprechend den Teilschaltungen der UND-Ebene aufgebaut ist, die vom Taktsignal für die UND-Ebene angesteuert wird und am Ausgang ein gegenüber dem Taktsignal für die UND-Ebene derart verzögertes Taktsignal für die ODER-Ebene abgibt, daß vor Umschalten von der Vorladephase in die Verarbeitungsphase vorher alle Teilschaltungen der UND-Ebene ihre Produkttermsignale erzeugt haben.

Um ein gleiches Verhalten der Taktverzögerungsschaltung im Vergleich zu den Teilschaltungen der UND-Ebene zu errei-

chen, besteht die Taktverzögerungsschaltung aus zwei Leitungen, von denen die eine zur Vorladung über einen von dem
Taktsignal für die UND-Ebene angesteuerten Takttransistor
mit dem ersten Betriebspotential und die andere über einen
von demselben Taktsignal angesteuerten komplementär ausgeführten Takttransistor mit dem zweiten Betriebspotential
verbindbar ist, und aus zwischen den zwei Leitungen angeordneten Transistoren, von denen mindestens einer ständig
leitend gesteuert ist, um die vorgeladene Leitung zur Erzeugung des Taktsignals für die ODER-Ebene zu entladen.

Die Verzögerungszeit für das Taktsignal für die ODER-Ebene
entspricht mindestens der des langsamsten Produktterms,
wenn pro Eingangsleitungspaar der UND-Ebene ein Transistor
in der Taktverzögerungsschaltung zwischen den Leitungen
angeordnet ist. Um den notwendigen Sicherheitsabstand zwischen unverzögertem und verzögertem Taktsignal zu erhalten,
kann in der Verzögerungsschaltung zusätzlich ein Kondensator an der Leitung angeordnet werden, die von dem Transistor entladen wird.

Bei Taktleitungen mit nicht zu vernachlässigender Signallaufzeit (z.B. Polysilizium) ist es notwendig, die Taktverzögerungsschaltung auf der Seite der UND-Ebene anzuordnen, die am weitesten von der Stelle abliegt, an der das
Taktsignal für die UND-Ebene zugeführt wird. Damit ist
sichergestellt, daß die Taktverzögerungsschaltung bei einem
Zustandswechsel des Taktsignals für die UND-Ebene zuletzt
angesteuert wird.

Sollte am Ausgang der ODER-Ebene zur Aufnahme der Summentermsignale ein getaktetes Register angeordnet sein, dann
ist es zweckmäßig, zur Erzeugung des Taktsignals für dieses
Register parallel zu den Teilschaltungen der ODER-Ebene
eine weitere Taktverzögerungsschaltung anzuordnen, die entsprechend der Taktverzögerungsschaltung in der UND-Ebene aufgebaut ist.

Andere Weiterbildungen der Erfindung ergeben sich aus den Unteransprüchen.

Anhand von Ausführungsbeispielen, die in den Figuren dargestellt sind, wird die Erfindung weiter erläutert. Es zeigen

Fig. 1 ein dynamisches C-MOS-PLA mit Taktverzögerung, bei der die ODER-Ebene mit n-MOS-Transistoren aufgebaut ist,

Fig. 2 ein dynamisches C-MOS-PLA mit Taktverzögerung, bei der die ODER-Ebene mit p-MOS-Transistoren aufgebaut ist,

Fig. 3 den Verlauf der Taktsignale für die UND-Ebene und die ODER-Ebene.

Fig. 4 ein dynamisches C-MOS-PLA mit zusätzlicher Taktverzögerung zur Ansteuerung eines Ausgangsregisters,

Fig. 5 den Verlauf der einzelnen Taktsignale,

Fig. 6 eine andere Ausführung eines dynamischen C-MOS-PLA mit Taktverzögerung.

Da der Aufbau einer programmierbaren Schaltung (PLA) in dynamischer C-MOS-Technik bekannt ist, wird darauf nur sehr kurz eingegangen. Ein PLA in dynamischer C-MOS-Technik besteht aus einer UND-Ebene UD und aus einer ODER-Ebene OD. Mit Hilfe der UND-Ebene UD werden aus Eingangssignalen, z.B. E1 bis E3, Produkttermsignale PT, z.B. PT1 bis PT3 erzeugt, die der ODER-Ebene OD zugeführt werden. Die ODER-Ebene erzeugt aus den Produkttermsignalen PT1 bis PT3 Summentermsignale ST, z.B. ST1 und ST2. Da in dynamischer C-MOS-Technik gearbeitet wird, ist zur Erzeugung jedes Produkttermsignals PT jeweils eine Teilschaltung SE1 vorgesehen. Jede Teilschaltung SE1 besteht aus zwei Leitungen L1 und L2, zwischen denen Verknüpfungstransistoren TV1 angeordnet sind. Die Leitung L1 ist zur Vorladung über einen Takttransistor TT1, im Ausführungsbeispiel ein p-Kanaltransistor, mit einem ersten Betriebspotential P1 verbindbar. Die Leitung L2 ist über einen Takttransistor TT2, im Ausführungsbeispiel ein n-Kanaltransistor, mit einem zweiten Betriebspotential P2 verbindbar. Den Takttransistoren TT1 und TT2 wird ein erstes Taktsignal TS1 für die UND-Ebene UD zugeführt.

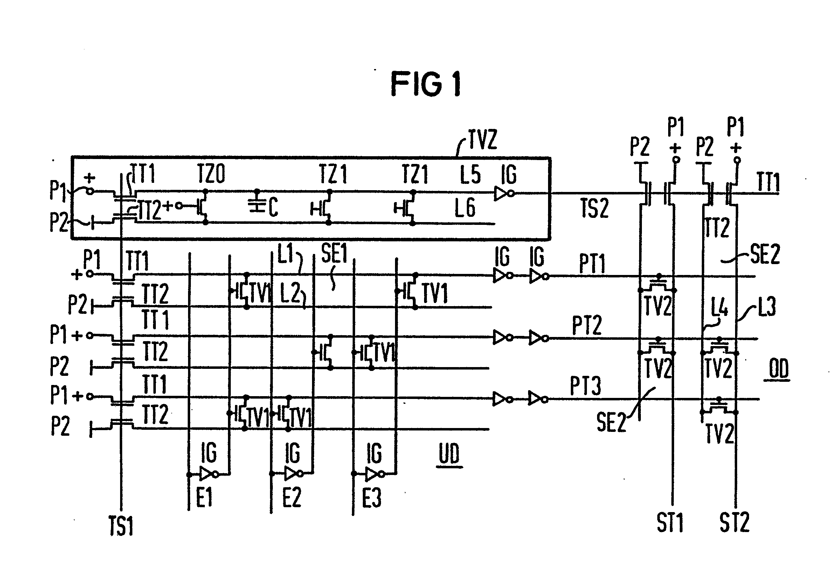

Im Ausführungsbeispiel werden die Eingangssignale E1 bis E3 direkt und über ein Inverterglied IG invertiert der UND-Ebene UD zugeführt. Entsprechend der gewünschten Programmierung werden an den Kreuzungspunkten zwischen den Leitungen für die Eingangssignale und den Leitungen der Teilschaltungen SE1 Verknüpfungstransistoren TV1 angeordnet, wie es z.B. in Fig. 1 dargestellt ist.

Im Betrieb werden mit Hilfe des Taktsignals TS1 für die UND-Ebene UD die Leitungen L1 der Teilschaltungen SE1 dadurch vorgeladen, daß der Takttransistor TT1 leitend gesteuert wird und damit das Betriebspotential P1 an die Leitungen L1 anlegt. Wenn das Taktsignal TS1 umschaltet, können die Verknüpfungstransistoren TV1 entsprechend den anliegenden Eingangssignalen E1 bis E3 die Leitungen L1 der Teilschaltungen SE1 entweder entladen oder nicht entladen. In dieser Verarbeitungsphase ist der Takttransistor TT1 gesperrt und der Takttransistor TT2 leitend gesteuert. Entsprechend der Anordnung der Verknüpfungstransistoren TV1 werden dadurch am Ausgang der UND-Ebene UD die Produkttermsignale PT1 bis PT3 gebildet.

Die ODEr-Ebene OD erzeugt nun aus den Produkttermsignalen PT Summentermsignale ST. Für die Erzeugung eines Summentermsignales ST ist jeweils eine Teilschaltung SE2 vorgesehen. Diese besteht aus zwei Leitungen L3 und L4, zwischen denen die Verknüpfungstransistoren TV2 in gewünschter Weise angeordnet sind. Die Steueranschlüsse dieser Verknüpfungstransistoren TV2 sind mit den Leitungen für die Produkttermsignale PT verbunden. Die eine Leitung L3 der Teilschaltung SE2 ist über einen Takttransistor TT1 mit einem ersten
Betriebspotential P1 zur Vorladung verbindbar, die Leitung
L4 ist über einen komplementär ausgeführten Takttransistor
TT2 mit einem Betriebspotential P2 verbindbar. Den Steuereingängen der Takttransistoren TT1 und TT2 wird das zweite
Taktsignal TS2 für die ODER-Ebene OD zugeführt.

Die Betriebsweise der ODER-Ebene OD ist vergleichbar mit
der der UND-Ebene UD. Durch Anlegen des Taktsignals TS2
werden die Leitungen L3 der Teilschaltungen SE2 dadurch
vorgeladen, daß der Takttransistor TT1 leitend gesteuert
wird und das Betriebspotential P1 an die Leitung L3 anlegt.
Die Schaltung befindet sich dann in der Vorladephase. Um
aus den anliegenden Produkttermsignalen PT die Summentermsignale ST zu bilden, schaltet das Taktsignal TS2 um, sperrt
den Transistor TT1 und steuert den Transistor TT2 leitend,
so daß die Verknüpfungstransistoren TV2 entsprechend den
anliegenden Produkttermsignalen PT die Leitungen L3 entladen können. Die Schaltung befindet sich damit in der Verarbeitungsphase.

Für den zeitlichen Verlauf des Taktsignals TS2 ist wichtig, daß dieser gegenüber dem Verlauf des Taktsignals TS1
so verzögert ist, daß die Summenterme ST erst dann endgültig gebildet werden, wenn alle Teilschaltungen SE1 der
UND-Ebene UD ihre Produkttermsignale erzeugt haben. Das
heißt die Verarbeitungsphase darf beim Taktsignal TS2 erst
dann auftreten, wenn die Produkttermsignale PT der UND-
Ebene UD sicher vorliegen. Um dies zu erreichen, ist die
Taktverzögerungsschaltung TVZ vorgesehen. Sie ist parallel
zu den Teilschaltungen SE1 der UND-Ebene UD angeordnet und
zwar so, daß sie gegenüber der Seite der UND-Ebene UD liegt,
der das Taktsignal TS1 zugeführt wird. Die Taktverzögerungsschaltung TVZ ist entsprechend den Teilschaltungen SE1 der UND-Ebene UD aufgebaut. Sie besteht aus zwei Leitungen L5 und L6, zwischen denen Transistoren TZ1 und TZ0 angeordnet sind. Die Leitung L5 ist entsprechend der Teilschaltung SE1 über einen Takttransistor TT1 mit dem Betriebspotential P1 verbindbar. Entsprechend ist die Leitung L6 über einen zum Takttransistor TT1 komplementär ausgeführten Takttransistor TT2 mit dem zweiten Betriebspotential P2 verbindbar. Die Takttransistoren TT1 und TT2 werden ebenfalls vom Taktsignal TS1 angesteuert. Von den Transistoren TZ0 und TZ1 ist nur ein Transistor, nämlich der Transistor TZ0 ständig leitend gesteuert, während die anderen Transistoren TZ1 ständig gesperrt sind. Damit ist die Taktverzögerungsschaltung TVZ mit der maximal möglichen kapazitiven Belastung versehen, die nur über einen einzigen Transistor, nämlich den Transistor TZ0 entladen wird. Da die Taktverzögerungsschaltung TVZ im Vergleich zur UND-Ebene UD gegenüber dem Eingang für das Taktsignal TS1 liegt, ist sichergestellt, daß die Taktverzögerungsschaltung bei einem Zustandswechsel des Taktsignals nach den Teilschaltungen SE1 angesteuert wird. Die Anzahl der Transistoren TZ0 und TZ1 in der Taktverzögerungsschaltung TVZ ist so gewählt, daß pro Eingangsleitungspaar (Eingang und invertierter Eingang) ein Transistor TZ vorgesehen ist. Um zusätzlich einen Sicherheitsabstand zwischen dem Schalten der langsamsten Teilschaltung SE1 und dem Schalten der Taktverzögerungsschaltung TVZ zu erreichen, ist in der Taktverzögerungsschaltung ein Kondensator C an der Leitung L5 angeschlossen. Der Kondensator C verursacht unabhängig von der Größe des PLA's eine zusätzliche konstante Taktverzögerung.

Mit einem derartigen Aufbau der Taktverzögerungsschaltung wird erreicht, daß der verzögerte Takt TS2 für die ODER-Ebene OD für jede beliebige Zahl von zu erzeugenden Produkttermen und für jede beliebige Zahl von Eingängen erst nach dem Schalten der langsamsten Teilschaltung SE1 der
UND-Ebene UD seinen logischen Zustand ändert.

Zur Wiederherstellung der richtigen Polarität des Taktsignales TS2 muß das von der Verzögerungsschaltung TVZ abgegebene Taktsignal mit Hilfe eines Invertergliedes IG invertiert werden. Sollte zwischen der UND-Ebene UD und der
ODER-Ebene OD eine Pufferschaltung für die Produkttermsignale PT angeordnet werden, z.B. zwei Invertergliedern IG,
so kann deren Auswirkung auf das Produkttermsignal durch
eine entsprechende Dimensionierung des Kondensators C ausgeglichen werden.

Da die Taktverzögerungsschaltung TVZ auf demselben Baustein
angeordnet ist wie das übrige PLA, wird die Taktverzögerungsschaltung TVZ von technologiebedingten Schwankungen
der Schaltungsparameter in gleicher Weise beeinflußt wie
die ODER-Ebene oder die UND-Ebene. Solche technologiebedingte Schwankungen sind somit bei der Erzeugung des Taktsignales TS2 berücksichtigt.

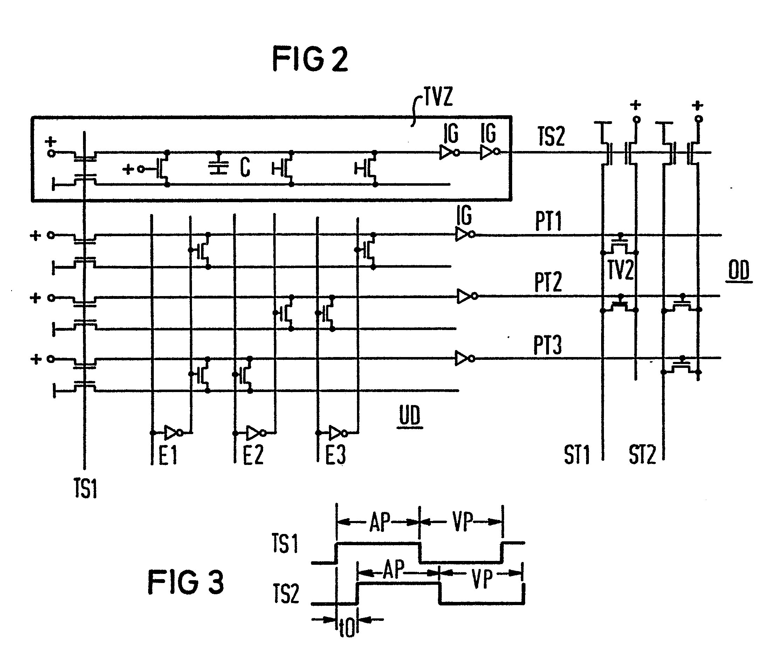

Aus Fig. 3 ergibt sich der zeitliche Verlauf der Taktsignale
TS1 und TS2. Das Taktsignal TS1 wird der UND-Ebene und der
Taktverzögerungsschaltung TVZ zugeführt. Während der Vorladephase VP des Taktsignales TS1 sind die Transistoren TT1
leitend gesteuert und die Leitungen L1 der Teilschaltungen
SE1 bzw. die Leitung L5 der Taktverzögerungsschaltung TVZ
sind an das Betriebspotential P1 angeschaltet. Schaltet das
Taktsignal TS1 um, dann folgt die Verarbeitungsphase AP.
Jetzt sind die Takttransistoren TT1 gesperrt und die Takttransistoren TT2 sind leitend gesteuert und schalten das
zweite Betriebspotential P2 an die Leitungen L2 der Teilschaltungen SE1 bzw. an die Leitung L6 der Taktverzögerungsschaltung TVZ. Die Entladung der Leitung L5 kann damit beginnen und entsprechend den Verknüpfungstransistoren TV1 werden die Leitungen L1 der Teilschaltungen SE2 umgeladen oder nicht umgeladen. Das Taktsignal TS2 am Ausgang der Taktverzögerungsschaltung TVZ erscheint somit verzögert gegenüber dem Taktsignal TS1. Durch Wahl der Anzahl der Transistoren TZ und durch Dimensionierung des Kondensators C kann die Verzögerungszeit $t_0$ zwischen dem Taktsignal TS2 und dem Taktsignal TS1 eingestellt werden, und zwar so, daß das Taktsignal TS2 erst dann von der Vorladephase VP zur Arbeitsphase AP übergeht, wenn die Teilschaltungen SE1 der UND-Ebene UD ihre Produkttermsignale PT erzeugt haben.

Die Fig. 2 zeigt eine leicht abgeänderte programmierbare Schaltung gegenüber der Fig. 1. Der Unterschied besteht darin, daß als Verknüpfungstransistoren TV2 jetzt p-Kanaltransistoren verwendet werden. In einem solchen Falle müssen die von der UND-Ebene UD abgegebenen Produkttermsignale invertiert werden, und zwar durch das Inverterglied IG und das von der Taktverzögerungsschaltung TVZ abgegebene Signal darf nicht invertiert sein. Aus diesem Grunde sind zwei Inverterglieder hintereinander geschaltet. Die erforderliche Verzögerungszeit $t_0$ zwischen dem Taktsignal TS2 und dem Taktsignal TS1 kann wieder auf einfache Weise mit Hilfe der Dimensionierung des Kondensators C in der Taktverzögerungsschaltung erreicht werden.

Um eine problemlose Handhabung der dynamischen PLA's zu gewährleisten, ist es vorteilhaft, an die Ein- und Ausgänge des PLA Register anzuordnen. Damit erscheint nach außen hin das PLA als statisch.

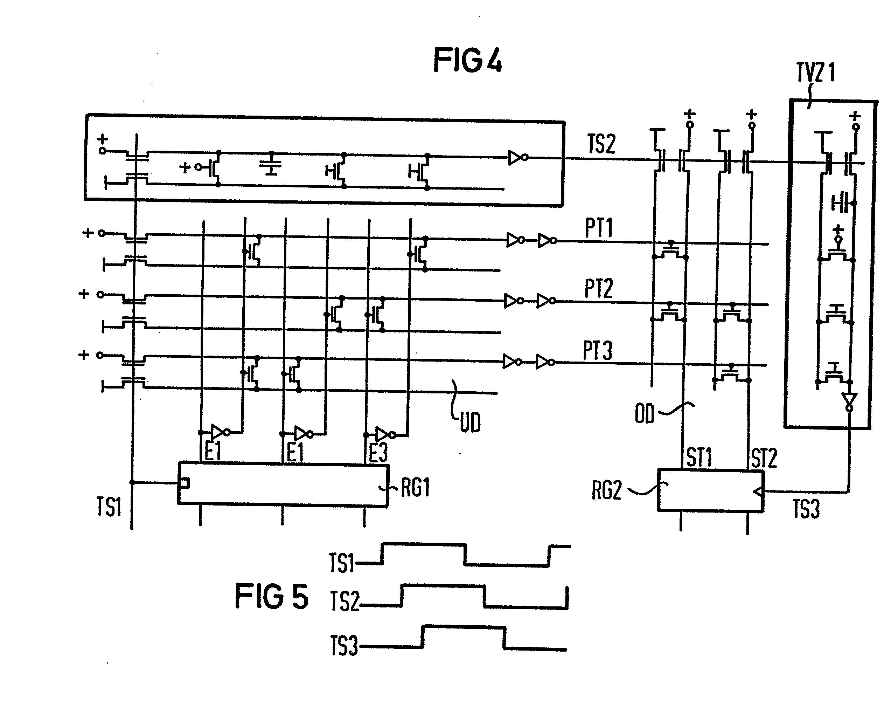

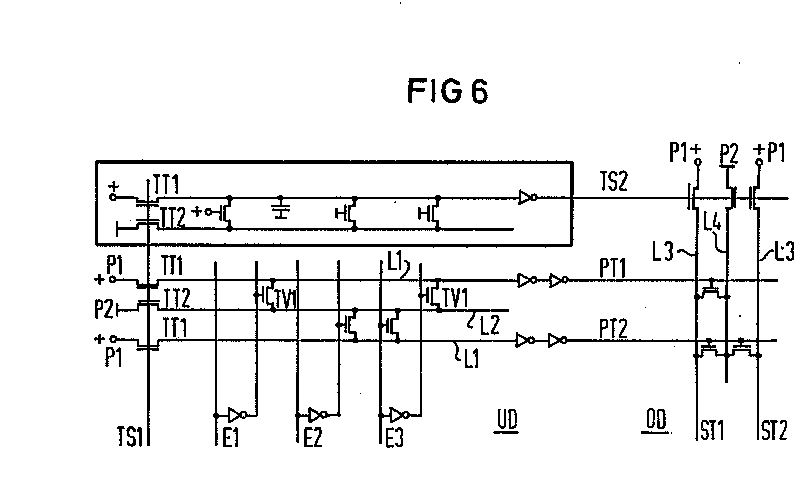

Fig. 4 zeigt einen derartigen Aufbau eines PLA. Zusätzlich zu der Anordnung nach Fig. 1 ist am Eingang der UND-Ebene UD ein getaktetes Register RG1 angeordnet, in dem die von der UND-Ebene UD zu verarbeitenden Eingangssignale gespei-chert sind. Das Register RG1 wird von den ersten Taktsignalen TS1 getaktet. Am Ausgang der ODER-Ebene OD ist ein zweites Register RG2 angeordnet, in dem die Summentermsignale ST zwischengespeichert werden. Dieses wird durch Taktsignale TS3 getaktet. Die Speicherung darf aber erst dann geschehen, wenn die Ausgänge der ODER-Ebene OD gültig sind, also alle Summentermsignale ST erzeugt worden sind. Aus diesem Grunde muß das Taktsignal TS3 gegenüber dem Taktsignal TS2 für die ODER-Ebene OD zeitlich verzögert auftreten. Es ist besonders vorteilhaft, wenn das Taktsignal TS3 mit Hilfe einer Taktverzögerungsschaltung TVZ1 gebildet wird, die entsprechend der Taktverzögerungsschaltung TVZ aufgebaut ist. Diese wird aber nun parallel zu den Teilschaltungen SE2 der ODER-Ebene OD angeordnet, wie es Fig. 4 zeigt. Damit ist es möglich, so wie es für die Taktverzögerungsschaltung TVZ beschrieben worden ist, aus dem Taktsignal TS2 ein zeitlich verzögertes Taktsignal TS3 für das Register RG2 zu erzeugen, wie es in Fig. 5 dargestellt ist.

Bei der Ausführungsform des PLA nach Fig. 6 sind die Leitungen L2 bzw. L4 von jeweils zwei nebeneinanderliegenden Teilschaltungen SE1 bzw. SE2 zusammengefaßt, um Fläche einzusparen. Damit verdoppelt sich die kapazitive Last, die über die Takttransistoren TT2 umgeladen werden muß. Diese Verhältnisse können in den Taktverzögerungsschaltungen TVZ bzw. TVZ1 dadurch nachgebildet werden, daß die Transistoren TT2 der Taktverzögerungsschaltungen TVZ bzw. TVZ1 nur halb so weit gemacht werden, wie die Transistoren TT2 der UND-Ebene bzw. der ODER-Ebene.

9 Patentansprüche
6 Figuren

0178437

VPA 84 P 1 7 2 0 E

Patentansprüche

1. Programmierbare Schaltung in dynamischer C-MOS-Technik mit einer UND-Ebene, die Eingangssignale zu Produkttermen zusammenfaßt, und mit einer ODER-Ebene, die die Produkttermsignale zu Summentermen zusammenfaßt, bei der die UND-Ebene zur Erzeugung eines Produkttermsignals bzw. die ODER-Ebene zur Erzeugung eines Summentermsignals jeweils eine Teilschaltung mit zwei Leitungen, von denen die eine zur Vorladung über einen von einem Taktsignal angesteuerten Takttransistor mit einem ersten Betriebspotential und die andere über einen zweiten von dem Taktsignal angesteuerten komplementär ausgeführten Takttransistor mit einem zweiten Betriebspotential verbindbar ist, und mit zwischen den Leitungen angeordneten von den Eingangssignalen bzw. Produkttermsignalen angesteuerten Verknüpfungstransistoren aufweist, dadurch  g e k e n n z e i c h - n e t ,  daß parallel zu den Teilschaltungen (SE1) der UND-Ebene (UD) zur Erzeugung des Taktsignals (TS2) für die Teilschaltungen (SE2) der ODER-Ebene (OD) eine Taktverzögerungsschaltung (TVZ) angeordnet ist, die entsprechend den Teilschaltungen (SE1) der UND-Ebene aufgebaut ist, vom Taktsignal (TS1) für die UND-Ebene angesteuert wird und ein gegenüber dem Taktsignal (TS1) für die UND-Ebene (UD) derart verzögertes Taktsignal (TS2) für die ODER-Ebene (OD) abgibt, daß vorher alle Teilschaltungen (SE1) der der UND-Ebene ihre Produkttermsignale (PT) erzeugt haben.

2. Programmierbare Schaltung nach Anspruch 1,  g e k e n n - z e i c h n e t   durch die Taktverzögerungsschaltung (TVZ) aus zwei Leitungen (L5, L6), von denen die eine (L5) zur Vorladung über einen von dem Taktsignal (TS1) für die UND-Ebene (UD) angesteuerten Transistor (TT1) mit dem ersten Betriebspotential (P1) und die andere über einen von demselben Taktsignal angesteuerten komplementär aus-

0178437

VPA 84 P 1720 E

geführten Takttransistor (TT2) mit dem zweiten Betriebspotential (P2) verbindbar ist, aus zwischen den zwei Leitungen (L5, L6) angeordneten Transistoren (TZ), von denen
mindestens einer (TZO) ständig leitend gesteuert ist, um
die vorgeladene Leitung (L5) zur Erzeugung des Taktsignals (TS2) für die ODER-Ebene zu entladen.

3. Schaltung nach Anspruch 2, dadurch g e k e n n -
z e i c h n e t , daß die Taktverzögerungsschaltung (TVZ)
pro Eingangsleitungspaar der UND-Ebene (UD) einen Transistor (TZ) aufweist.

4. Schaltung nach Anspruch 2 oder 3, dadurch g e -
k e n n z e i c h n e t , daß in der Taktverzögerungsschaltung (TVZ) zur zusätzlichen Einstellung der Verzögerungszeit ein Kondensator (C) angeordnet ist, der mit
der entladbaren Leitung (L5) verbunden ist.

5. Schaltung nach einem der vorhergehenden Ansprüche,
dadurch g e k e n n z e i c h n e t , daß die Taktverzögerungsschaltung (TVZ) auf der Seite der UND-Ebene (UD)
angeordnet ist, die am weitesten von der Stelle abliegt,
an der das Taktsignal (TS1) der UND-Ebene zugeführt wird.

6. Anordnung nach Anspruch 4 oder 5, dadurch g e -
k e n n z e i c h n e t , daß der von zwischen der UND-
Ebene und der ODER-Ebene angeordneten Schaltkreisen verursachte Einfluß auf die Laufzeit der Produktermsignale
durch die Dimensionierung des Kondensators (C) in der
Taktverzögerungsschaltung (TVZ) berücksichtigt ist.

7. Schaltung nach einem der vorhergehenden Ansprüche,
dadurch g e k e n n z e i c h n e t , daß am Ausgang
der ODER-Ebene (OD) ein getaktetes Register (RG2) angeordnet ist, das die Summentermsignale (ST) speichert.

8. Schaltung nach Anspruch 7, dadurch  g e k e n n -
z e i c h n e t ,  daß zur Erzeugung des Registertaktes
(TS3) parallel zu den Teilschaltungen (SE2) der ODER-
Ebene (OD) eine entsprechend der Taktverzögerungsschaltung (TVZ) aufgebaute Schaltung (TVZ1) angeordnet ist.  .

9. Schaltung nach Anspruch·8, dadurch  g e k e n n -
z e i c h n e t ,  daß jeweils zwei benachbart liegende
Teilschaltungen (SE1 bzw. SE2) eine gemeinsame andere
Leitung (L2 bzw. L4) haben, und daß der Transistor (TT2)
der Taktverzögerungsschaltung (TVZ bzw. TVZ1) nur eine
halbe Weite gegenüber den Transistoren (TT2) der UND-
Ebene (UD) bzw. ODER-Ebene (OD) aufweist.

# FIG 1

0178437

FIG 2

FIG 3

# FIG 4

## FIG 5

0178437

# FIG 6

0178437

**0178437**
Nummer der Anmeldung

**EUROPÄISCHER RECHERCHENBERICHT**

Europäisches Patentamt

EP 85 11 1040

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-3 974 366 (HEBENSTREIT) * Figur 3; Seite 4, Zeile 7 - Seite 5, Zeile 57 * | 1,2,7 | H 03 K 19/177 |
| A | | 9 | |
| Y | IBM TECHNICAL DISCLOSURE BULLETIN, Band 24, Nr. 6, November 1981, Seite 3103, New York, US; D.A. KLUGA: "Clocked PLA with dummy circuit forming clock pulse for inter-array driver with worst-case delay" * Seite 3103, Zeilen 1-11 * | 1,2,7 | |
| A | IEEE JOURNAL OF SOLID-STATE CIRCUITS, Band SC-16, Nr. 2, April 1981, Seiten 103-107, IEEE, New York, US; CHONG MING LIN: "A 4mum NMOS NAND structure PLA" * Figur 2; Seite 104, rechte Spalte, Zeile 49 - Seite 106, linke Spalte, Zeile 11 * | 1,2,7 8 | |

RECHERCHIERTE SACHGEBIETE (Int. Cl.4)

H 03 K

Der vorliegende Recherchenbericht wurde für alle Patentansprüche erstellt.

| Recherchenort | Abschlußdatum der Recherche | Prüfer |
|---|---|---|
| DEN HAAG | 18-12-1985 | FEUER F.S. |